# EUROPÄISCHE PATENTSCHRIFT

(11) **EP 3 284 113 B1**
(45) Veröffentlichungstag und Bekanntmachung des Hinweises auf die Patenterteilung: **13.09.2023**
(21) Anmeldenummer: 16725752.6
(22) Anmeldetag: 15.04.2016
(51) Int. Cl.: H01L 33/48, H01L 25/075, H01L 33/50, H01L 33/54

(54) **VERFAHREN ZUR HERSTELLUNG EINES LED-MODUL ZUR ABGABE VON WEISSLICHT**
METHOD FOR MANUFACTURING LED MODULE FOR EMITTING WHITE LIGHT
PROCÉDÉ DE FABRICATION D'UN MODULE À DEL POUR L'ÉMISSION D'UNE LUMIÈRE BLANCHE

(30) Priorität: 17.04.2015 DE 102015206972
(43) Veröffentlichungstag der Anmeldung: 21.02.2018
(73) Patentinhaber: Tridonic GmbH & Co. KG, 6850 Dornbirn (AT)
(72) Erfinder: PACHLER, Peter, 8042 Graz (AT)
(74) Vertreter: Rupp, Christian
(86) Internationale Anmeldenummer: PCT/AT2016/050099
(87) Internationale Veröffentlichungsnummer: WO 2016/164954

(56) Entgegenhaltungen:
- EP-A1- 2 293 354
- EP-A1- 2 717 338
- EP-A2- 2 365 525
- EP-A2- 2 479 812
- EP-A2- 2 492 577
- DE-A1-102013 109 890
- DE-U1-202014 103 029
- US-A1- 2007 284 563
- US-A1- 2012 162 979

## Beschreibung

### 1. Gebiet der Erfindung

Die vorliegende Erfindung betrifft ein Verfahren zur Herstellung eines LED-Moduls zur Abgabe von Licht aus mehreren unterschiedlichen Lichtquellen welche sich vorzugsweise zu Weißlicht mischen. Weiterhin werden ein LED-Modul (Leuchtdioden-Modul) und eine Leuchtvorrichtung mit zumindest einem solchen LED-Modul offenbart, jedoch nicht explizit beansprucht.

### 2. Hintergrund

Aus dem Stand der Technik sind LED-Module bekannt, die zur Abgabe von Weißlicht. Diese LED-Module weisen in der Regel ein lichtabstrahlendes Lichtfeld auf, das durch eine Kombination einzelner Lichtpunkte gebildet wird. Die einzelnen Lichtpunkte sind dazu ausgelegt, unterschiedliche Lichtspektren abzugeben. Beispielsweise wird von den Lichtpunkten blaues Licht, rotes Licht und von einem Leuchtstoff erzeugtes gelbes Licht abgegeben. Die Lichtpunkte werden typischerweise mit einem sogenannten Globe-Top Verfahren gebildet Ferner sind sogenannte SMD-Komponenten bekannt, wie beispielsweise in dem Produkt Philips HUE ausgeführt, bei dem Dispenstropfen direkt auf die einzelnen LED-Chips aufgebracht werden.

Solche LED-Module weisen allerdings ein im Vergleich zu nicht steuerbaren Lichtquellen ein relativ großes Lichtfeld auf und das Licht muss zudem in einer Mischkammer homogenisiert werden was zusätzlichen Bauraum erfordert und was dazu führt, dass Leuchten einen den ästhetischen Ansprüchen ungenügend großen Reflektor benötigen. Derartige Lichtfelder, wenn diese kostengünstig und mit hoher Effizienz hergestellt werden sollen, weisen typischerweise einen Durchmesser von wenigstens 19 mm (unter der Annahme von etwa 2000+lm Lichtstrom) auf, wobei es mit den bekannten Globe-Top Verfahren grundsätzlich nicht möglich ist den Durchmesser des Lichtfelds weiter zu verringern, wenn eine ausreichend große Lichtabstrahlfläche bereitgestellt werden soll.

Ferner sind beispielsweise aus der DE 20 2014 103 029 U1 LED-Module mit Lichtfeldern bekannt, die unterschiedlich ausgebildete flächige Bereiche zum Abgeben von unterschiedlichen Lichtspektren umfassen. Diese flächigen Bereiche sind dabei jeweils durch Dämme bzw. Trennwände von den weiteren flächigen Bereichen getrennten. In die jeweils durch die Dämme getrennten Bereiche werden LED-Chips bzw. LED-Stränge angeordnet und mit einer einen Leuchtstoff bzw. eine Leuchtstoffmischung enthaltende Vergussmasse bedeckt. Die Vergussmassen weisen dabei unterschiedliche Leuchtstoffe bzw. unterschiedliche Leuchtstoffmischungen auf, so dass die Bereiche die gewünschten unterschiedlichen Lichtspektren abgeben können, die notwendig sind, um ein entsprechendes Mischlicht durch das LED-Modul bereitstellen zu können. Dabei müssen die Dämme zwischen den flächigen Bereichen eine gewisse Mindesthöhe und eine gewisse Mindestbreite aufweisen, um ein Überlaufen und damit ein Vermischen der unterschiedlichen Vergussmassen zu verhindern. Ein homogener (Misch-)Lichteindruck kann dabei umso besser bereitgestellt werden, je mehr von den separaten flächigen Bereichen vorgesehen sind. Bei solchen Ausführungsformen kann es dabei allerdings von Nachteil sein, dass die Dämme eine vergleichsweise große Fläche des Lichtfelds benötigen und diese Fläche demgemäß nicht mehr als Lichtabstrahlfläche zur Verfügung steht.

Aus der EP 2 717 338 A1 ist ein LED-Modul zur Abgabe von Mischlicht bekannt, das ebenfalls die zuvor genannten Dämme umfasst.

Aus der EP 2 479 812 A2 ist ein Verfahren zur Herstellung eines LED-Moduls zur Abgabe von Mischlicht bekannt, das eine flüssige Vergussmasse mit bereits darin dispergiertem Leuchtstoff in einem Bereich oberhalb der jeweiligen LED-Chips aufbringt. Dabei benötigt das Verfahren Rahmenstrukturen, die dieselbe Funktion aufweisen wie die zuvor genannten Dämme.

Die Dokumente US2012162979 A1 und US2007284563 A1 offenbaren jeweils ein Verfahren zur Herstellung eines LED-Moduls zur Abgabe von Mischlicht.

Im Lichte dieses Standes der Technik ist es Aufgabe der vorliegenden Erfindung, ein Verfahren zur Herstellung eines LED-Moduls zur Abgabe von Mischlicht, vorzugsweise ein (Misch-)Weißlicht, bereitzustellen, das den bekannten Stand der Technik verbessert. Insbesondere sollen LED-Module bereitgestellt werden können, die herstellungsbedingt keine Dämme im Lichtfeld mehr benötigen, so dass möglichst die gesamte Fläche des Lichtfelds als Lichtabstrahlfläche zur Verfügung steht.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafterweise weiter.

### 3. Ausführliche Beschreibung der Erfindung

Ein nicht explizit beanspruchtes LED-Modul zur Abgabe von Mischlicht, vorzugsweise von Weißlicht, aufweisend zumindest:
eine Modulplatte mit zumindest einem Damm, der zumindest ein Lichtfeld begrenzt, wobei innerhalb des zumindest einen Lichtfelds mehrere in einer Vergussmasse eingebettete LED-Chips angeordnet sind, und
wobei im Bereich um einen jeweiligen LED-Chip selektiv ein Leuchtstoff oder eine Leuchtstoffmischung angeordnet ist. Selektiv bedeutet somit, dass die Konzentration des Leuchtstoffs bzw. der Mischung um den LED-Chip herum sowie auf dessen Oberseite grösser ist als im Mittenbereich zwischen den Chips.

Mit anderen Worten, es wird vorgeschlagen, den Leuchtstoff nicht mehr innerhalb eines durch einen Damm umgrenzten Lichtfelds bzw. eines durch einen Damm umgrenzten Teilbereichs eines Lichtfelds mehr oder weniger homogen zu verteilen, sondern jeden LED-Chip selektiv mit einem entsprechenden Leuchtstoff zu versehen. Es besteht somit keine Notwendigkeit mehr, die jeweiligen LED-Chips bzw. die unterschiedlichen flächigen Bereiche durch Dämme innerhalb des Lichtfelds voneinander zu trennen. Somit kann die eingesparte Fläche entweder als weitere Lichtabstrahlfläche zur Verfügung stehen oder die Größe des Lichtfelds kann ohne Leistungseinbuße entsprechend verkleinert werden.

Ein Leuchtstoff ist dabei allgemein ein Stoff, der durch Licht, das von den verwendeten LED-Chips emittiert werden kann, anregbar ist und daraufhin ein sekundäres Lichtspektrum abgibt. Vorzugsweise werden in der vorliegenden Erfindung anorganische Leuchtstoffe oder auch ein Quantumdot eingesetztbeispielsweise ZnS, ZnSe, CdS, CdSe, ZnTe, CdTe). Vorzugsweise wird durch den Leuchtstoff sekundäres Licht aus dem gelben, grünen und/oder roten Spektrumbereich abgegeben, wenn die Anregung durch blaues Licht erfolgt, bei Verwendung von tiefblauen Licht (<420 nm) oder UV-Licht ist auch eine Emission von blauen Licht erforderlich. Weitere vorliegend einsetzbare Leuchtstoffe sind zum Beispiel: Silikate (Ca₃Sc₂Si₃O₁₂: Ce3+), Ortho-Silikate (B.O.S.E.: zB. (Ba, Sr, Ca)₂SiO₄:Eu²⁺, (Ba, Sr)₂SiO₄:Eu²⁺, (Ba, Ca)₂SiO₄:Eu²⁺, (Sr, Ca)₂SiO₄:Eu²⁺), Granate (YAG: Ce³⁺, (YGd)AG: Ce³⁺, LuAG: Ce³⁺), Oxides (CaScO₂: Eu²⁺), SiALONs (a-SiALON: Eu²⁺, b-SiALON: Eu²⁺), Nitride (La₃Si₆N₁₁: Ce³⁺, CaAlSiN₃:Ce³⁺), Oxy-Nitride (SrSi₂N₂O₂: Eu²⁺, (Ca,Sr,Ba)Si₂N₂O₂: Eu²⁺).

Die vorliegende Beschreibung versteht dabei unter Licht aus dem roten Lichtspektrum Licht mit einer Peakwellenlänge zwischen etwa 580 und 670 nm, unter Licht aus dem blauen Lichtspektrum Licht mit einer Peakwellenlänge zwischen etwa 390 bis 480 nm, unter Licht aus dem grünen Lichtspektrum Licht mit einer Peakwellenlänge zwischen etwa 480 und 560 nm und unter Licht aus dem gelben Lichtspektrum Licht mit einer Peakwellenlänge zwischen 560 und 630 nm.

Vorteilhafterweise ist die Vergussmasse eine Vergussmasse auf Silikon- und/oder Epoxidbasis, welche in den für die Funktion wichtigen spektralen Bereichen vorzugsweise bereits im flüssigen und vorzugsweise zumindest im vernetzten Zustand vollständig transparent ist. Weiterhin ist es bevorzugt, dass die flüssige Vergussmasse selbst keinen durch das von den LED-Chips emittierte Licht anregbaren Leuchtstoff enthält. Die Vergussmasse kann jedoch zusätzlich Streupartikel zur homogeneren Lichtdurchmischung beinhalten.

Es ist bevorzugt, dass in dem zumindest einen Lichtfeld LED-Chips angeordnet sind, die ein blaues Lichtspektrum emittieren, wobei es weiterhin bevorzugt ist, dass nur ein blaues Lichtspektrum emittierende LED-Chips in dem zumindest einem Lichtfeld angeordnet sind. Auf diesen bzw. an diesen kann dabei grüner, gelber oder roter Leuchtstoff oder eine Mischung davon angeordnet werden. Eine Anordnung von nur blauen LED-Chips im Lichtfeld wird besonders bevorzugt, um ein sogenanntes 2-Kanal-Lichtfeld bereitzustellen, also ein Lichtfeld, mit dem zwei Spektren (beispielsweise ein grünes und ein rotes Spektrum) bereitgestellt und gemischt werden können. Auch kann es bevorzugt sein nur in bestimmten Bereichen des zumindest einen Lichtfelds LED-Chips, die ein blaues Lichtspektrum emittierende vorzusehen.

Ferner ist es bevorzugt im Lichtfeld LED-Chips anzuordnen, die ein rotes oder blaues Lichtspektrum emittieren. Auch hier kann auf diesen bzw. an diesen grüner, gelber oder roter Leuchtstoff oder eine Mischung davon angeordnet werden. Dabei ist es bevorzugt, dass nur die blauen LED-Chips mit einem grünen, gelben oder roten Leuchtstoff versehen werden und an den roten LED-Chips kein Leuchtstoff aufgebracht wird bzw. kein Leuchtstoff, der durch ein rotes Lichtspektrum nicht angeregt wird. Eine Anordnung von blauen und roten LED-Chips im Lichtfeld wird besonders bevorzugt, um ein sogenanntes 3-Kanal-Lichtfeld bereitzustellen, also ein Lichtfeld, mit dem drei Spektren (beispielsweise ein rotes, ein grünes und ein gelbes Spektrum) bereitgestellt und gemischt werden können.

In diesem Zusammenhang ist darauf hinzuweisen, dass sich die vorliegende Beschreibung nicht auf eine bestimmte LED-Chip/Leuchtstoff-Farbkombination beschränkt. Vielmehr kann jeder LED-Chip mit einem gewünschten und geeigneten Leuchtstoff versehen werden, um ein entsprechendes Mischlicht bereitstellen zu können. Die LED-Chips können beispielsweise blauleuchtende, rotleuchtende, grünleuchtende, gelbleuchtende oder im UV-Bereich leuchtende LED-Chips umfassen. Das abgegebene Lichtspektrum kann dabei durch ein Zusammenspiel zwischen den jeweiligen LED-Chips und der in der Vergussmasse an dem bzw. um den LED-Chip angeordneten Leuchtstoff zustande kommen, oder direkt von einem LED-Chip erzeugt werden. Somit kann rotes, grünes, gelbes, grün-gelbes oder weißes Licht mit unterschiedlichen Weißtönen durch die LED-Chips bzw. durch die LED-Chip/Leuchtstoff-Kombinationen emittiert werden.

Vorteilhafterweise sind die LED-Chips als sogenannte LED-Stränge in dem zumindest einen Lichtfeld angeordnet, wobei es in diesem Fall ferner bevorzugt ist, dass oberhalb der LED-Chips eines jeweiligen LED-Strangs der gleiche Leuchtstoff bzw. die gleiche Leuchtstoffmischung auf die Vergussmasse aufgebracht wird. Die LED-Stränge sind dabei vorzugsweise separat oder in miteinander verschalteten Gruppen (je nach Anzahl der eingesetzten LED-Stränge) ansteuerbar. Somit können beispielsweise LED-Stränge, die zur Abgabe eines ersten Lichtspektrums vorgesehen sind und LED-Stränge, die zur Abgabe eines zweiten Lichtspektrums vorgesehen sind, jeweils in Gruppen miteinander verschaltet werden. Dadurch kann ein beliebiges Mischlicht im Bereich zwischen dem ersten und dem zweiten Lichtspektrum eingestellt und abgegeben werden. Die LED-Chips bzw. die LED-Stränge des Lichtfeldes können vorzugsweise einzeln oder gemeinsam derart ansteuerbar sein, dass ihre Leuchtfarbe durch die Ansteuerung veränderbar ist. Ferner kann jeder LED-Strang bzw. jede miteinander verschaltete Gruppe von LED-Chips oder LED-Strängen einzeln gedimmt werden, beispielsweise mittels Pulsbreiten-Modulation.

Vorzugsweise weist der Damm (bzw. die Dämme) eine in Draufsicht gesehene Breite zwischen 50 µm und 2 mm auf, besonders bevorzugt zwischen 300 µm und 1,5 mm und weiter bevorzugt zwischen 500 µm und 1000 µm. Der Damm wird dabei entweder unmittelbar auf der Modulplatte gebildet, beispielsweise durch das Auftragen und das Ausgehärten eines geeigneten Materials (durch ein sogenanntes Dispensverfahren) oder der Damm wird zunächst als separates Bauteil hergestellt das anschließend mit der Modulplatte verbunden wird. Weiterhin ist es bevorzugt, dass der Damm mit einer hauptsächlich diffus reflektierenden weißen Oberfläche ausgebildet ist oder mit einer spiegelnden metallischen Oberfläche.

Vorteilhafterweise sind innerhalb des durch den zumindest einen umschließenden Damms des zumindest einen Lichtfelds keine weiteren Dämme mehr vorgesehen. Es können allerdings auch mehrere jeweils durch einen Damm begrenzte Lichtfelder auf der Modulplatte vorgesehen werden.

Vorzugsweise ist das durch den zumindest einen Damm umfasste Lichtfeld kreisförmig und weist vorzugsweise eine Lichtstromdichte von > 5 lm/mm² auf woraus sich für ein Lichtstrompacket von 2000 lm ein Durchmesser des Lichtfeldes von ca. 23 mm ergibt. Durch die angewandte Erfindung kann jedoch eine Lichtstromdichte von 10 lm/mm² bis 20 lm/mm² erreicht werden, was zu Lichtfelddurchmesser von ca. 16 mm bis ca. 11 mm für ein Lichtstrompacket von 2000 lm führt.

Vorteilhafterweise kann das LED-Modul ferner auf die Anwendung einer Lichtstreuscheibe verzichten. In speziellen Fällen kann die Anordnung einer Lichtstreuscheibe dennoch von Vorteil sein. Die Lichtstreuscheibe verleiht dem LED-Modul einen noch homogeneren Farbeindruck, d.h. durch die Streuung des Lichts wird die Vermischung der unterschiedlichen Lichtspektren, die von dem Lichtfeld abgegeben werden, nochmals verbessert. Zwischen dem Lichtfeld und der Lichtstreuscheibe kann ferner eine sogenannte Mischkammer vorgesehen werden. Die Mischkammer ist vorzugsweise dazu ausgelegt, eine effektive Durchmischung der verschiedenen Lichtspektren, die vom Lichtfeld abgegeben werden, zu erzielen. Dazu können in der Mischkammer beispielsweise optische Elemente, wie Linsen oder Reflektoren, vorgesehen sein. Die Mischkammer kann aber auch ein solider Block aus einem Material sein, das einen hohen Brechungsindex, beispielweise von 1,5 oder mehr aufweist. Insgesamt wird durch die Mischkammer und die Lichtstreuscheibe zusammen erreicht, dass die einzelnen Lichtspektren, die vom Lichtfeld abgegeben werden, nicht mehr von einem Betrachter des LED-Moduls unterscheidbar sind, sondern als homogenes Mischlicht, vorzugsweise homogenes Weißlicht, erscheinen.

Dabei ist es bevorzugt, dass eines der Lichtspektren zumindest einen Peak im Bereich zwischen 520 bis 580 nm aufweist. Weiterhin ist es bevorzugt, dass eines der Lichtspektren zumindest 2 Peaks aufweist, wobei ein Peak vorzugsweise im Bereich zwischen 520 bis 580 nm und ein Peak vorzugsweise im Bereich zwischen 580 bis 650 nm liegt. Ferner kann ein Lichtspektrum mit mehreren Peaks (beispielsweise 455 nm, 520 nm und 630 nm) emittiert werden.

Vorzugsweise sind die LED-Chips und die Leuchtstoffe so gewählt, dass das Lichtfeld geeignet ist, um Weißlicht mit mindestens 2 unterschiedlichen Farbtemperaturen zu emittieren, so dass beispielsweise Weißlicht mit unterschiedlichen Farbtemperaturen abgegeben werden kann (beispielsweise sogenannte kalt- und/oder warmweiße Spektren). Dabei ist es bevorzugt, dass eine erste Farbtemperatur im Bereich zwischen 5.000 K bis 1.800 K und eine zweite Farbtemperatur im Bereich zwischen 10.000 K bis 2.500 K liegt. Naturgemäß kann der Plancksche Kurvenzug auf dem die Weißfarborte per Definition liegen mit Geraden nur in relativ nahen Farbtemperaturbereichen gut nachgestellt werden, aus diesem Grunde sind Farbtemperaturbereiche von 6000 K bis 3000 K, 4000 K bis 3000 K oder 2700 K bis 1800 K bevorzugte Bereiche um beispielsweise einen Tageslichtverlauf, ein kontinuierliches Umschalten zwischen gängigen Innraumbeleuchtungen oder das Dimmen einer Glühbirne nachzustellen.

Ein erfindungsgemäßes Verfahren zur Herstellung eines LED-Moduls zur Abgabe von Mischlicht, vorzugsweise von Weißlicht, umfasst zumindest die folgenden Schritte: Bereitstellen einer Modulplatte mit zumindest einem Damm, der zumindest ein Lichtfeld begrenzt, wobei innerhalb des zumindest einen Lichtfelds LED-Chips angeordnet sind; Aufbringen einer flüssigen Vergussmasse auf das Lichtfeld derart, dass die LED-Chips von der Vergussmasse bedeckt werden; Aufbringen eines zumindest einem LED-Chip zugeordneten Leuchtstoffs auf die flüssige Vergussmasse selektiv in einem Bereich vertikal über dem LED-Chip, derart dass der Leuchtstoff in der flüssigen Vergussmasse absinkt und in einem Bereich um und auf dem LED-Chip verbleibt, wobei eine Konzentration des Leuchtstoffs um den jeweiligen LED-Chip herum sowie auf dessen Oberseite größer ist als in einem Mittenbereich zwischen den LED-Chips, wobei in einer Flüssigkeit bzw. Matrix dispergierte Leuchtstoffpartikel auf die flüssige Vergussmasse aufgebracht werden, und wobei die flüssige Vergussmasse und/oder der Leuchtstoff durch ein Dispensverfahren aufgebracht wird/werden.

Mit anderen Worten schlägt die vorliegende Erfindung vor, zunächst in ein durch einen Damm umgrenztes Lichtfeld eine flüssige Vergussmasse einzubringen. Anschließend wird oberhalb der einzelnen LED-Chips jeweils ein dem jeweiligen LED-Chip zugeordneter Leuchtstoff auf die noch flüssige Vergussmasse (vorzugsweise auf die Oberfläche der Vergussmasse) aufgebracht. Der Leuchtstoff (d.h. die Leuchtstoffpartikel) sinken anschließend in der Vergussmasse ab und setzt sich dabei auf der Oberfläche des LED-Chips und ggf. in der unmittelbaren Nachbarschaft (maximal 50%, vorzugsweise 30% der LED-Chip Abmessung in der Aufsicht) des LED-Chips auf dem Boden des Lichtfelds ab. In dieser Position kann der Leuchtstoff anschließend durch Aushärten der Vergussmasse fixiert werden.

In einem Abstand von 150%, bevorzugt 100%, weiter vorzugsweise 50% der entsprechenden Chip-Abmessung in der Aufsicht ist somit die LeuchtstoffKonzentration bevorzugt weniger als 20%, vorzugsweise 10%, noch mehr bevorzugt 5%, noch mehr bevorzugt 2% der mittleren Leuchtstoffkonzentration auf der Oberseite des LED-Chips.

"100%" bedeuten also bei einer Chip-Kantenlänge in der x-Achse oder y-Achse (Aufsicht auf den Chip von oben) von 1mm (als Beispiel) einen benachbarten Rand von 1 mm.

Je nach Anwendung kann es dabei auch von Vorteil sein, dass sich zwischen den einzelnen LED-Chips Mischbereiche (d.h. Bereiche an denen Leuchtstoff verschiedener LED-Chips angeordnet ist) mit entsprechender Queranregung ergeben. Soweit diese Queranregung unerwünscht ist, kann dem durch die Dosierung des Leuchtstoffs, durch die Beabstandung der LED-Chips oder durch angepasste Leuchtstoffmischungen entgegengewirkt werden.

Erfindungsgemäß, durch die Dosierung des Leuchtstoffs und durch eine exakte Ausrichtung der Leuchtstoffaufbringung (möglichst zentral oberhalb des jeweiligen LED-Chips), wird es gewährleistet, dass der Leuchtstoff nur den jeweiligen LED-Chip bedeckt und nicht in benachbarte Bereiche auf den Boden den Lichtfelds absinkt, so dass auch die Ausbildung von Mischbereichen entsprechend minimiert wird.

Somit besteht durch das erfindungsgemäße Verfahren die Möglichkeit unterschiedliche Leuchtstoffe bzw. unterschiedliche Leuchtstoffmischungen selektiv an den jeweiligen LED-Chips anzuordnen, ohne dass die Notwendigkeit besteht, die jeweiligen LED-Chips bzw. die unterschiedlichen flächigen Bereiche durch Dämme innerhalb des Lichtfelds voneinander zu trennen. Somit kann die eingesparte Fläche entweder als weitere Lichtabstrahlfläche zur Verfügung stehen oder die Größe des Lichtfelds kann ohne Leistungseinbuße entsprechend verkleinert werden.

Erfindungsgemäß wird der Leuchtstoff als Flüssigkeit mit darin dispergierten Leuchtstoffpartikeln auf die flüssige Vergussmasse aufgebracht. Es besteht jedoch auch die Möglichkeit, den Leuchtstoff als Leuchtstoffpulver auf die flüssige Vergussmasse aufzubringen bzw. aufzustreuen.

Erfindungsgemäß ist es, sowohl die flüssige Vergussmasse als auch den Leuchtstoff in flüssiger Form durch ein Dispensverfahren aufzubringen. Ein Dispensverfahren eignet sich vorliegend besonders gut, da damit flüssige Medien relativ genau dosiert und positioniert werden können. Soweit der Leuchtstoff in Form von Flüssigkeitstropen dispensiert wird, ist es bevorzugt, dass die Flüssigkeitstropfen einen Durchmesser zwischen 0,5 mm und 5 mm aufweisen, vorzugsweise zwischen 1 mm und 4 mm und besonders bevorzugt zwischen 2 mm und 3 mm. Es hat sich herausgestellt, dass bei diesen Tropfengrößen einerseits eine vergleichsweise genaue Positionierung bei Anwendung eines Dispensverfahrens oberhalb der LED-Chips vorgenommen werden kann und andererseits zu große und ggf. unerwünschte Mischbereiche, in denen Queranregungen auftreten könnten, vermieden werden können.

Die vorliegende Beschreibung betrifft darüber hinaus eine nicht beanspruchte Leuchtvorrichtung, die zumindest ein oben beschriebenes LED-Modul umfasst.

### 4. Beschreibung von bevorzugten Ausführungsformen

Nachfolgend wird eine detaillierte Beschreibung der Figuren gegeben. Darin zeigt:
- **Figur 1**: eine schematische Querschnittsansicht eines LED-Moduls nachdem Leuchtstoff auf die Oberfläche der Vergussmasse dispensiert wurde;
- **Figur 2**: eine schematische Querschnittsansicht, die einen vergrößerten Ausschnitt aus Figur 1 zeigt;
- **Figur 3**: eine der Figur 2 entsprechende schematische Querschnittsansicht nach dem Absinken des Leuchtstoffs;
- **Figur 4**: eine schematische Draufsicht auf ein (2-Kanal-)LED-Modul;
- **Figur 5**: eine schematische Draufsicht auf ein weiteres (Mehrkanal-)LED-Modul.

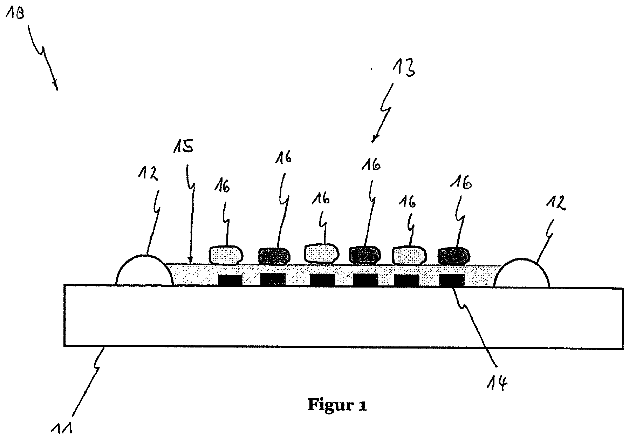

Nachfolgend wird zunächst ein erfindungsgemäßes Verfahren zur Herstellung eines LED-Moduls 10 mit Bezug auf die Figuren 1 bis 3 erläutert.

In einem ersten Schritt wird eine Modulplatte 11 mit (zumindest) einem Damm 12, der vorzugsweise ein im Wesentlichen kreisförmiges Lichtfeld 13 umgrenzt, und mit innerhalb des Lichtfelds 13 angeordneten LED-Chips 14 bereitgestellt.

Vorzugsweise weist der Damm 12 eine in Draufsicht gesehene Breite zwischen 50 µm und 2 mm auf. Der Damm 12 kann dabei entweder unmittelbar auf der Modulplatte 11 gebildet werden oder zunächst als separates Bauteil hergestellt werden, das anschließend mit der Modulplatte 11 verbunden wird.

Die LED-Chips 14 können beispielsweise blauleuchtende, rotleuchtende, grünleuchtende, gelbleuchtende oder im UV-Bereich leuchtende LED-Chips 14 sein. In der in Figur 1 gezeigten Ausführungsformen sind in dem Lichtfeld 13 baugleiche LED-Chips 14 angeordnet, die vorzugsweise ein blaues Lichtspektrum emittieren. Auf diesen bzw. an diesen kann grüner, gelber oder roter Leuchtstoff oder eine Mischung davon angeordnet werden.

In einem weiteren Schritt wird im Bereich des Lichtfelds 13 eine flüssige Vergussmasse 15 eingebracht und zwar derart, dass die LED-Chips 14 im Wesentlichen vollständig mit Vergussmasse 15 bedeckt sind. Die flüssige Vergussmasse 15 ist vorzugsweise auf Silikon- und/oder Epoxidbasis gebildet und ist im gehärteten Zustand vorzugsweise transparent. Weiterhin ist es bevorzugt, dass die flüssige Vergussmasse 15 keinen durch das von den LED-Chips 14 emittierte Licht anregbaren Leuchtstoff enthält.

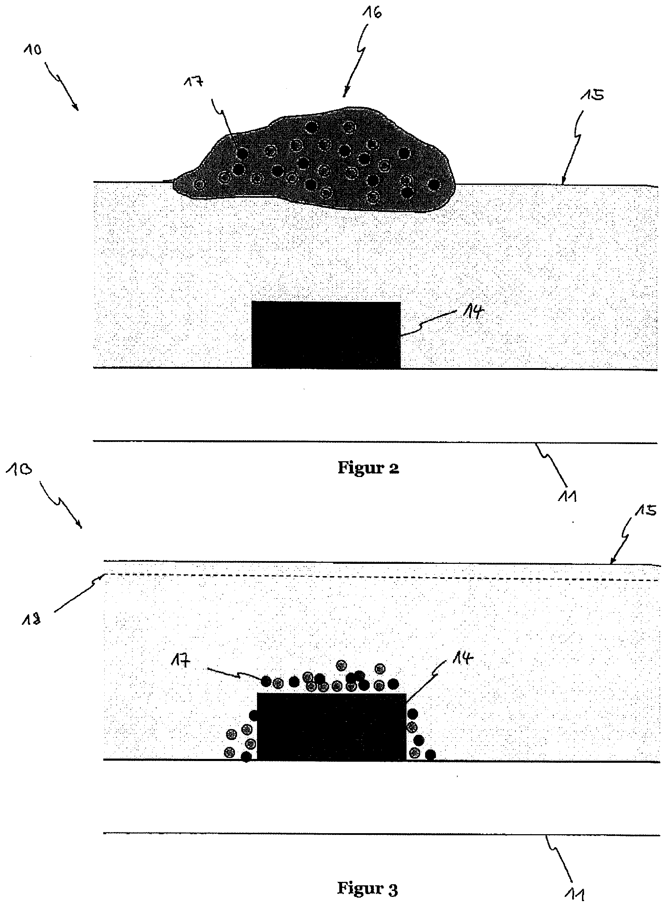

In nächsten Schritt wird Leuchtstoff, vorliegend als Flüssigkeitstropfen 16 mit darin dispergierten Leuchtstoffpartikeln 17, auf die Oberfläche der flüssigen Vergussmasse 15 aufgebracht. Vorteilhafterweise basieren die Flüssigkeitstropfen 16 dabei ebenfalls auf demselben Material, wie die flüssige Vergussmasse 15, damit beim späteren Aushärten ein möglichst homogener Verbund bereitgestellt werden kann. Die Flüssigkeitstropfen 16 weisen dabei etwa einen Durchmesser von 0,1 mm bis 1,0 mm auf. Beim Einbringen der Vergussmasse 15 ist weiterhin zu beachten, dass die Flüssigkeitstropfen 16 das Flüssigkeitsniveau innerhalb des Lichtfelds 13 erhöhen. In Figur 3 ist die Erhöhung des Flüssigkeitsniveaus aufgrund der dispensierten Flüssigkeitstropfen 16 durch die gestrichelte Linie 18 angedeutet.

Als Leuchtstoff werden vorzugsweise anorganische Leuchtstoffe oder ein Q-dot eingesetzt (beispielsweise ZnS, ZnSe, CdS, CdSe, ZnTe, CdTe). Vorzugsweise wird durch den Leuchtstoff sekundäres Licht aus dem gelben, grünen und/oder roten Spektrumbereich abgegeben. Weitere vorliegend einsetzbare Leuchtstoffe sind: Silikate (Ca₃Sc₂Si₃O₁₂: Ce3+), Ortho-Silikate (B.O.S.E.), Granate (YAG: Ce³⁺, (YGd)AG: Ce³⁺, LuAG: Ce³⁺), Oxides (CaScO₂: Eu²⁺), SiALONs (□-SiALON: Eu²⁺, □-SiALON: Eu²⁺), Nitride (La₃Si₆N₁₁: Ce³⁺, (Ca, Sr) AlSiN₃:Ce³⁺, CaAlSiN₃:Ce³⁺), Oxy-Nitride (SrSi₂N₂O₂: Eu²⁺, (Ca,Sr,Ba)Si₂N₂O₂: Eu²⁺).

Wie in Figur 3 gezeigt, sinken die Leuchtstoffpartikel 17 aufgrund der Schwerkraft in der flüssigen Vergussmasse 15 ab und lagern sich dabei auf und an den LED-Chips 14 ab, so dass diese später durch das von den LED-Chips 14 emittierte Licht angeregt werden können und ein sekundäres Licht abgegeben können. Schließlich wird die Vergussmasse 15 mit den darin abgesetzten Leuchtstoffpartikeln 17 gehärtet, so dass sich ein fester Verbund ergibt.

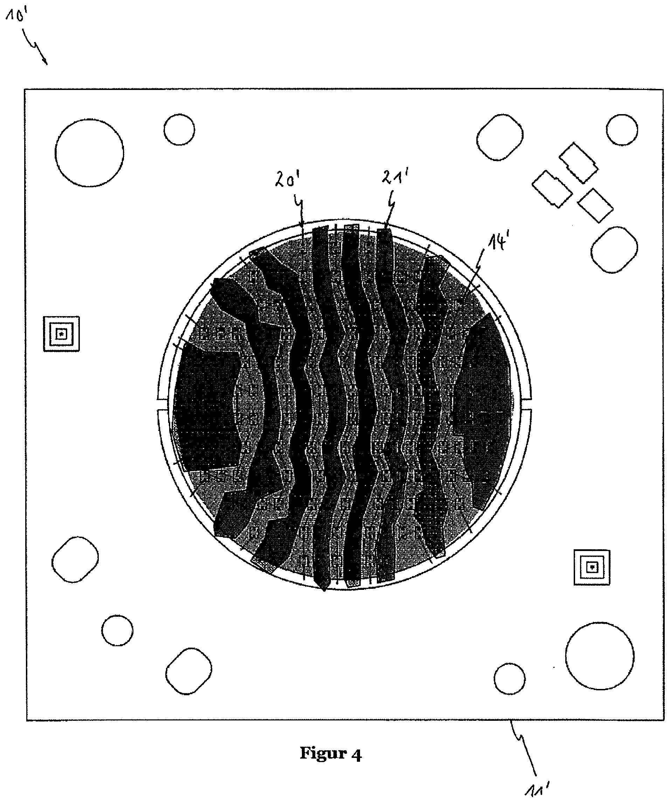

Figur 4 zeigt eine bevorzugte Ausführungsform eines LED-Moduls 10'. Bei dem gezeigten LED-Modul 10' handelt es sich um eine sogenannte 2-Kanal-Variante (d.h. mit dem LED-Modul 10' können zwei Lichtspektren gemischt werden), wobei lediglich LED-Chips 14', die blaues Licht emittieren verwendet wurde, auf die entweder roter oder grüner Leuchtstoff, wie oben beschrieben, aufgebracht wurde.

Die LED-Chips 14' sind dabei als LED-Stränge 20', 21' gruppiert und miteinander verschaltet (in Figur 4 ist exemplarisch jeweils nur ein LED-Strang 20', 21' mit einem Bezugszeichen versehen), wobei die mit dem gleichen Leuchtstoff versehenen LED-Chips 14' jeweils als LED-Strang 20' bzw. 21' miteinander verschaltet sind. Durch die zwei unterschiedlichen Leuchtstoffe (in der gezeigten bevorzugten Ausführungsform abwechselnd grüner Leuchtstoff auf den LED-Strängen 20' und roter Leuchtstoff auf den LED-Strängen 21') ergibt sich ein entsprechendes Mischlicht eines ersten und zweiten Lichtspektrums. Die LED-Stränge 20', 21' sind vorzugsweise einzeln oder gemeinsam derart ansteuerbar, dass ihre Leuchtfarbe durch die Ansteuerung veränderbar ist. Weiterhin ist es bevorzugt, dass jeder LED-Strang 20', 21' bzw. jede miteinander verschaltete Gruppe von LED-Strängen einzeln gedimmt werden kann, beispielsweise mittels Pulsbreiten-Modulation. Anzumerken ist, dass sich bei der in Figur 4 gezeigten Ausführungsform zwischen benachbarten LED-Strängen 20', 21' Mischbereiche ergeben bzw. können. Soweit dies nicht erwünscht ist, kann entweder die Tropfengröße beim Dispensieren bzw. der Leuchtstoffpartikelanteil angepasst werden oder es können aufeinander angepasste Leuchtstoffmischungen verwendet werden.

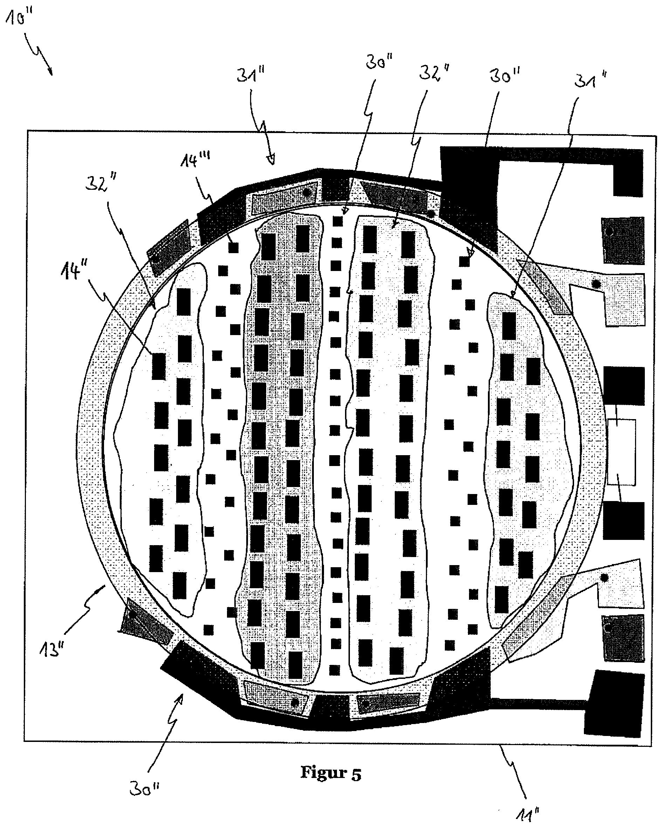

Figur 5 zeigt eine weitere Ausführungsform eines LED-Moduls 10".Bei dem gezeigten LED-Modul 10" handelt es sich dabei um eine sogenannte 3-Kanal-Variante (d.h. durch das LED-Modul 10" können drei Lichtspektren gemischt werden).

Im Unterschied zu der in Figur 4 gezeigten Ausführungsform, sind vorliegend LED-Chips 14" die ein blaues Lichtspektrum emittieren (in Figur 5 durch die größere Rechteckflächen angedeutet) und LED-Chips 14‴ (in Figur 5 durch die kleineren Rechteckflächen angedeutet), die ein rotes Lichtspektrum emittieren im Lichtfeld 13" angeordnet.

In dem gezeigten Ausführungsbeispiel wurde oberhalb der roten LED-Chips 14‴ kein Leuchtstoff angeordnet bzw. dispergiert, wohingegen oberhalb der blauen LED-Chips 14" gelber und grüner Leuchtstoff angeordnet bzw. dispergiert wurde. Mit dem in Figur 5 gezeigten LED-Modul 10" kann somit ein grünes (durch die blauen LED-Chips 14" und dem grünen Leuchtstoff), ein rotes (unmittelbar durch die roten LED-Chips 14‴) und ein gelbes (durch die blauen LED-Chips 14" und dem gelben Leuchtstoff) Lichtspektrum gemischt bzw. bereitgestellt werden.

In der gezeigten bevorzugten Ausführungsform umfasst das Lichtfeld 13" somit drei rot emittierende Bereiche 30", zwei gelb emittierende Bereiche 31" und zwei grün emittierende Bereiche 32".

In einer weiteren Ausführungsform können oberhalb der blauen LED-Chips 14" Leuchtstoffmischungen von gelben und grünen (orangen) Leuchtstoffen angeordnet bzw. dispergiert werden. Beispielsweise können diese Mischungen unterschiedliche Anteile von grünen und gelben Leuchtstoffen enthalten. Das Lichtfeld 13" zeigt somit mehrere weißlich emittierende Bereiche 31" mit unterschiedlichen Farbtönen bzw. Farbtemperaturen auf.

Die vorliegende Erfindung ist nicht auf die vorhergehenden Ausführungsbeispiele beschränkt, solange sie vom Gegenstand der folgenden Ansprüche umfasst ist. Insbesondere sind alle oben beschriebenen Lichtfelder in einem oben beschriebenen LED-Modul verwendbar, so dass die jeweiligen Erläuterungen hinsichtlich des mit dem LED-Moduls bzw. der jeweiligen Lichtfeldern grundsätzlich für alle Lichtfelder gelten, soweit nicht explizit Unterschiede hervorgehoben wurden. Darüber hinaus ist anzumerken, dass die vorliegende Erfindung nicht auf eine bestimmte LED-Chip/Leuchtstoff-Farbkombination beschränkt ist. Auch ist die vorliegende Erfindung nicht darauf beschränkt, dass zwingend alle im Lichtfeld angeordneten LED-Chips mit Leuchtstoff versehen werden.

## Patentansprüche

1. Verfahren zur Herstellung eines LED-Moduls (10, 10', 10") zur Abgabe von Mischlicht, vorzugsweise von Weißlicht, umfassend zumindest die folgenden Schritte:
- Bereitstellen einer Modulplatte (11) mit zumindest einem Damm (12), der zumindest ein Lichtfeld (13) begrenzt, wobei innerhalb des zumindest einen Lichtfelds (13) LED-Chips (14, 14', 14", 14‴) angeordnet sind;
- Aufbringen einer flüssigen Vergussmasse (15) auf das Lichtfeld (13) derart, dass die LED-Chips (14, 14', 14", 14‴) von der Vergussmasse (15) bedeckt werden;
- Aufbringen eines einem LED-Chip (14, 14', 14", 14‴) zugeordneten Leuchtstoffs (16, 17) auf die flüssige Vergussmasse (15) in einem Bereich oberhalb des LED-Chips (14, 14', 14", 14‴), derart dass der Leuchtstoff in der flüssigen Vergussmasse (15) absinkt und in einem Bereich um den LED-Chip (14, 14', 14", 14‴) verbleibt, wobei eine Konzentration des Leuchtstoffs (16, 17) um den jeweiligen LED-Chip (14, 14', 14", 14‴) herum sowie auf dessen Oberseite größer ist als in einem Mittenbereich zwischen den LED-Chips (14, 14', 14", 14‴),
wobei in einer Flüssigkeit bzw. Matrix (16) dispergierte Leuchtstoffpartikel (17) auf die flüssige Vergussmasse (15) aufgebracht werden, und wobei die flüssige Vergussmasse (15) und/oder der Leuchtstoff (16, 17) durch ein Dispensverfahren aufgebracht wird/werden.

2. Verfahren nach Anspruch 1, wobei in dem zumindest einen
Lichtfeld (13) LED-Chips (14, 14', 14", 14‴) angeordnet sind, die ein blaues Lichtspektrum emittieren, vorzugsweise sind in dem zumindest einen Lichtfeld (13) nur LED-Chips (14, 14', 14", 14‴) angeordnet, die ein blaues Lichtspektrum emittieren.

3. Verfahren nach einem der Ansprüche 1 oder 2, wobei in dem zumindest einen Lichtfeld (13) LED-Chips (14, 14', 14", 14‴) angeordnet sind, die ein rotes oder ein blaues Lichtspektrum emittieren.

4. Verfahren nach einem der Ansprüche 1 bis 3, wobei jeweils oberhalb der blaues Lichtspektrum emittierenden LED-Chips (14, 14', 14", 14‴) grüner, gelber oder roter Leuchtstoff oder eine Mischung davon auf die flüssige Vergussmasse (15) aufgebracht wird, und wobei jeweils oberhalb der ein rotes Lichtspektrum emittierenden LED-Chips (14, 14', 14", 14‴) kein Leuchtstoff aufgebracht wird und/oder ein Leuchtstoff, der durch ein rotes Lichtspektrum nicht angeregt wird.

5. Verfahren nach einem der vorhergehenden Ansprüche, wobei der Leuchtstoff (16, 17) auf die flüssige Vergussmasse (15) derart aufgebracht wird, dass der Leuchtstoff (16, 17) nur im Bereich um einen jeweiligen LED-Chip (14, 14', 14", 14‴) angeordnet ist, und
wobei der Leuchtstoff ein anorganischer Leuchtstoff oder ein Quantumdot ist.

6. Verfahren nach einem der vorhergehenden Ansprüche, wobei die LED-Chips (14, 14', 14", 14‴) als LED-Stränge (20`, 21') in dem zumindest einen Lichtfeld (13) angeordnet sind, und wobei der Leuchtstoff (16, 17) so angeordnet wird, dass im Bereich um einen jeweiligen LED-Chip (14, 14', 14", 14‴) eines LED-Strangs (20`, 21') der gleiche Leuchtstoff angeordnet ist.

7. Verfahren nach einem der vorhergehenden Ansprüche, wobei der Damm (12) eine in Draufsicht gesehene Breite zwischen 50 µm und 2 mm aufweist, bevorzugt zwischen 300 µm und 1,5 mm und weiter bevorzugt zwischen 500 µm und 1000 µm, und wobei der Damm (12) reflektierend ausgebildet ist, vorzugsweise mit einer weißen oder metallisierten Oberfläche.

8. Verfahren nach einem der vorhergehenden Ansprüche, wobei innerhalb des zumindest einen Lichtfelds (13) kein weiterer Damm vorgesehen ist.

9. Verfahren nach einem der vorhergehenden Ansprüche, wobei das durch den zumindest einen Damm (12) umfasste Lichtfeld (13) kreisförmig ist und eine Lichtstromdichte von > 5 lm/mm² bereitstellt und bei einem Lichtstrompaket von 2000 lm einen Durchmesser von etwa 23 mm aufweist, vorzugsweise wird eine Lichtstromdichte zwischen 10 lm/mm² bis 20
lm/mm² bereitgestellt und bei einem Lichtstrompaket von 2000 lm vorzugsweise ein Lichtfelddurchmesser zwischen etwa 16 mm bis etwa 11 mm.

10. Verfahren nach einem der vorhergehenden Ansprüche, ferner aufweisend die Schritte:
- Anordnen einer Lichtstreuscheibe in Lichtabstrahlrichtung beabstandet an dem zumindest einen Lichtfeld (13), und
- Vorsehen einer Mischkammer zwischen der Lichtstreuscheibe und dem zumindest einen Lichtfeld (13), wobei die Mischkammer durch ein rohrförmiges Element bereitgestellt wird, das am Austrittsende ein diffuses Element, wie eine Milchglasscheibe, umfasst.

## Claims

1. Method for producing an LED module (10, 10', 10") for emitting mixed light, preferably white light, comprising at least the following steps:
- providing a module plate (11) having at least one dam (12) which delimits at least one light field (13), wherein LED chips (14, 14', 14", 14"') are arranged within the at least one light field (13);
- applying a liquid potting compound (15) to the light field (13) such that the LED chips (14, 14', 14", 14‴) are covered by the potting compound (15);
- applying a phosphor (16, 17) associated with an LED chip (14, 14', 14", 14"') to the liquid potting compound (15) in a region above the LED chip (14, 14', 14", 14‴) such that the phosphor falls in the liquid potting compound (15) and remains in a region around the LED chip (14, 14', 14", 14‴), wherein a concentration of the phosphor (16, 17) is greater around the relevant LED chip (14, 14', 14", 14"`) and on its upper face than in a central region between the LED chips (14, 14', 14", 14‴),
wherein phosphor particles (17) dispersed in a liquid or matrix (16) are applied to the liquid potting compound (15), and wherein the liquid potting compound (15) and/or the phosphor (16, 17) is/are applied by a dispensing method.

2. Method according to claim 1, wherein LED chips (14, 14', 14", 14"`) which emit a blue light spectrum are arranged in the at least one light field (13), preferably only LED chips (14, 14', 14", 14"`) which emit a blue light spectrum are arranged in the at least one light field (13).

3. Method according to either claim 1 or claim 2, wherein LED chips (14, 14', 14", 14"`) which emit a red or a blue light spectrum are arranged in the at least one light field (13).

4. Method according to any of claims 1 to 3, wherein above the LED chips (14, 14', 14", 14‴) which emit blue light spectrum in each case, green, yellow or red phosphor or a mixture thereof is applied to the liquid potting compound (15), and wherein above the LED chips (14, 14', 14", 14"`) which emit a red light spectrum in each case, no phosphor is applied and/or a phosphor which is not excited by a red light spectrum is applied.

5. Method according to any of the preceding claims, wherein the phosphor (16, 17) is applied to the liquid potting compound (15) such that the phosphor (16, 17) is arranged only in the region around a relevant LED chip (14, 14', 14", 14"'), and
wherein the phosphor is an inorganic phosphor or a quantum dot.

6. Method according to any of the preceding claims, wherein the LED chips (14, 14', 14", 14"') are arranged as LED strands (20', 21') in the at least one light field (13), and wherein the phosphor (16, 17) is arranged such that the same phosphor is arranged in the region around a relevant LED chip (14, 14', 14", 14"`) of an LED strand (20', 21').

7. Method according to any of the preceding claims, wherein the dam (12) has a width, viewed in plan view, between 50 µm and 2 mm, preferably between 300 µm and 1.5 mm, and more preferably between 500 µm and 1000 µm, and wherein the dam (12) is designed to be reflective, preferably with a white or metal surface.

8. Method according to any of the preceding claims, wherein no further dam is provided within the at least one light field (13).

9. Method according to any of the preceding claims, wherein the light field (13) comprised by the at least one dam (12) is circular and provides a luminous flux density of > 5 lm/mm² and has a diameter of approximately 23 mm in a luminous flux package of 2000 lm, preferably a luminous flux density between 10 lm/mm² to 20 lm/mm² is provided and, in the case of a luminous flux package of 2000 lm, preferably a light field diameter between approximately 16 mm to approximately 11 mm.

10. Method according to any of the preceding claims, further comprising the steps of:
- arranging a light-scattering pane in the light emission direction spaced from the at least one light field (13), and
- providing a mixing chamber between the light-scattering pane and the at least one light field (13), wherein the mixing chamber is provided by a tubular element which, at the exit end, comprises a diffuse element, such as a frosted glass pane.

## Revendications

1. Procédé de fabrication d'un module à DEL (10, 10', 10") permettant d'émettre de la lumière mixte, de préférence de la lumière blanche, comprenant au moins les étapes suivantes :
- fourniture d'une plaque de module (11) comportant au moins un barrage (12) délimitant au moins un champ lumineux (13), des puces DEL (14, 14', 14", 14"`) étant disposées à l'intérieur de l'au moins un champ lumineux (13) ;
- application d'une masse de scellement (15) liquide sur le champ lumineux (13), de telle sorte que les puces DEL (14, 14', 14", 14"`) sont recouvertes par la masse de scellement (15) ;
- application d'un luminophore (16, 17) associé à une puce DEL (14, 14`, 14", 14‴) sur la masse de scellement (15) liquide dans une zone au-dessus de la puce DEL (14, 14', 14", 14"'), de telle sorte que le luminophore s'enfonce dans la masse de scellement (15) liquide et reste dans une zone autour de la puce DEL (14, 14', 14", 14"'), dans lequel une concentration du luminophore (16, 17) est plus grande autour de la puce DEL (14, 14', 14", 14"') respective et sur sa face supérieure que dans une zone centrale entre les puces DEL (14, 14', 14", 14"'),
dans lequel des particules de luminophore (17) dispersées dans un liquide ou une matrice (16) sont appliquées sur la masse de scellement (15) liquide, et dans lequel la masse de scellement (15) liquide et/ou le luminophore (16, 17) sont appliqués par un procédé de distribution.

2. Procédé selon la revendication 1, dans lequel des puces DEL (14, 14', 14", 14‴) qui émettent un spectre lumineux bleu sont disposées dans l'au moins un champ lumineux (13), de préférence seules des puces DEL (14, 14', 14", 14"') qui émettent un spectre lumineux bleu sont disposées dans l'au moins un champ lumineux (13).

3. Procédé selon l'une des revendications 1 ou 2, dans lequel des puces DEL (14, 14', 14", 14"') qui émettent un spectre lumineux rouge ou un spectre lumineux bleu sont disposées dans l'au moins un champ lumineux (13).

4. Procédé selon l'une des revendications 1 à 3, dans lequel, respectivement au-dessus des puces DEL (14, 14', 14", 14‴) émettant spectre lumineux bleu, un luminophore vert, jaune ou rouge ou un mélange de ceux-ci est appliqué sur la masse de scellement (15) liquide, et dans lequel, respectivement au-dessus des puces DEL (14, 14', 14", 14‴) émettant un spectre lumineux rouge, aucun luminophore n'est appliqué et/ou un luminophore qui n'est pas excité par un spectre lumineux rouge est appliqué.

5. Procédé selon l'une des revendications précédentes, dans lequel le luminophore (16, 17) est appliqué sur la masse de scellement (15) liquide de telle sorte que le luminophore (16, 17) est disposé uniquement dans la zone autour d'une puce DEL (14, 14', 14", 14‴) respective, et
dans lequel le luminophore est un luminophore inorganique ou un point quantique.

6. Procédé selon l'une des revendications précédentes, dans lequel les puces DEL (14, 14', 14", 14‴) sont disposées sous la forme de lignes de DEL (20', 21') dans l'au moins un champ lumineux (13), et dans lequel le luminophore (16, 17) est disposé de telle sorte que, dans la zone autour d'une puce DEL (14, 14', 14", 14‴) respective d'une ligne de DEL (20', 21'), le même luminophore est disposé.

7. Procédé selon l'une des revendications précédentes, dans lequel le barrage (12) présente une largeur, vue du dessus, comprise entre 50 µm et 2 mm, de préférence entre 300 µm et 1,5 mm et de manière davantage préférée entre 500 µm et 1 000 µm, et dans lequel le barrage (12) est réfléchissant, de préférence avec une surface blanche ou métallisée.

8. Procédé selon l'une des revendications précédentes, dans lequel aucun autre barrage n'est prévu à l'intérieur de l'au moins un champ lumineux (13).

9. Procédé selon l'une des revendications précédentes, dans lequel le champ lumineux (13) entouré par l'au moins un barrage (12) est circulaire et fournit une densité de flux lumineux > 5 lm/mm² et présente un diamètre d'environ 23 mm pour un paquet de flux lumineux de 2 000 lm, de préférence une densité de flux lumineux comprise entre 10 lm/mm² à 20 lm/mm² est fournie et, pour un paquet de flux lumineux de 2 000 lm, de préférence un diamètre de champ lumineux compris entre environ 16 mm à environ 11 mm.

10. Procédé selon l'une des revendications précédentes, présentant en outre les étapes de :
- disposition d'un panneau de diffusion de lumière dans le sens de rayonnement de la lumière à distance de l'au moins un champ lumineux (13), et
- prévision d'une chambre de mélange entre le panneau de diffusion de lumière et l'au moins un champ lumineux (13), dans lequel la chambre de mélange est fournie par un élément tubulaire qui, au niveau de l'extrémité de sortie, comprend un élément diffus, tel qu'un panneau en verre dépoli.
